# DEMANDE DE BREVET EUROPEEN

(11) **EP 1 912 075 A1**
(43) Date de publication de la demande: **16.04.2008**
(21) Numéro de dépôt: 06122219.6
(22) Date de dépôt: 12.10.2006
(51) Int. Cl.: G01P 15/097, H03H 9/19, H03H 9/21

(54) **Acceleromètre resonant comportant un resonateur en forme de diapason équipé de balourds**

(71) Demandeur: CSEM Centre Suisse d'Electronique et de Microtechnique SA Recherche et Développement, 2007 Neuchâtel (CH)
(72) Inventeur: BOURGEOIS, Claude, 2014, Bôle (CH)
(74) Mandataire: GLN

(57) **Abrégé**

L'invention concerne un accéléromètre (10) résonant qui est susceptible de mesurer l'intensité d'une accélération selon un axe sensible (Z) et qui comporte un résonateur (12) en forme de diapason comportant deux bras (18) longitudinaux plats identiques parallèles dans un plan de référence (P) orthogonal à l'axe sensible (Z), les deux bras (18) étant susceptibles d'osciller simultanément selon un premier mode de vibration (M1) en flexion planaire et selon un deuxième mode de vibration (M2) en torsion, les deux modes de vibration (M12) étant couplés l'un à l'autre, le diapason comportant une fréquence propre de vibration (F12), caractérisé en ce que le couplage est obtenu de manière cinétique par l'agencement sur chaque bras (18) d'un balourd (24) dont le centre de gravité (G) est décalé par rapport au plan de référence (P) de façon à induire une torsion des bras (18) lors de leurs oscillations transversales.

## Description

### Domaine technique

L'invention concerne un accéléromètre résonant qui comporte un résonateur en forme de diapason.

L'invention concerne plus particulièrement un accéléromètre résonant qui est susceptible de mesurer l'intensité d'une accélération selon un axe sensible et qui comporte :
- un résonateur en forme de diapason comportant deux bras longitudinaux plats identiques parallèles entre eux qui s'étendent depuis une extrémité encastrée jusqu'à une extrémité libre dans un plan de référence orthogonal à l'axe sensible, les deux bras étant susceptibles d'osciller simultanément selon un premier mode de vibration en flexion planaire dans lequel les extrémités libres oscillent transversalement et selon un deuxième mode de vibration en torsion autour de leur axe longitudinal, les deux modes de vibration étant couplés l'un à l'autre ; et
- des moyens d'actuation pour exciter l'oscillation des bras du résonateur à une fréquence propre de vibration.

Une accélération selon l'axe sensible provoque une flexion conjointe des bras hors du plan de référence, la fréquence propre du résonateur variant linéairement par rapport à l'amplitude de la flèche des bras.

Un accéléromètre résonant comporte un résonateur qui possède au moins une fréquence propre de vibration. Lorsque le résonateur est soumis à une accélération selon un axe sensible de mesure, la structure du résonateur est déformée ou contrainte de manière que sa fréquence propre varie proportionnellement à l'intensité de l'accélération mesurée. En d'autres termes, l'accéléromètre résonant répond à un stimulus déterminé, ici l'accélération, par un fort anisochronisme de fréquence. Ainsi, en mesurant le décalage de la fréquence propre du résonateur, il est possible d'en déduire l'intensité et le sens de l'accélération.

### Etat de la technique

On connaît déjà [Eernisse E. O. et al., "Survey of Quartz Bulk Resonator Sensors Technologies", IEEE Transactions on Ultrasonics, Ferroelectronics and Frequency Control, 35, No. 3, May 1988, pp 1994-2003] des accéléromètres comportant un résonateur en forme de double diapason. Les bras du résonateur subissent des contraintes de traction ou de compression longitudinales qui sont induites par l'accélération mesurée. La fréquence propre du mode de vibration en flexion des bras varie proportionnellement à l'intensité de ces contraintes induites, et donc proportionnellement à l'intensité de l'accélération mesurée.

Cependant, la fréquence propre varie de façon non linéaire par rapport à l'intensité de l'accélération; ce qui rend peu commode l'utilisation d'un tel capteur.

Il est aussi connu d'équiper certaines montres à quartz d'un résonateur en forme de diapason réalisé en quartz.

Ce résonateur est réalisé en quartz dit "X+α °", c'est-à-dire que le substrat du résonateur est pivoté d'un angle "α " (typiquement de 2 à 5°) autour de l'axe électrique X. Les montres équipées de tels résonateurs présentent, du fait de l'anisotropie élastique du quartz (via son coefficient de complaisance S₂₄), un effet de position dû à la gravitation qui peut être gênant.

Dans la montre, le quartz est soumis à un champ électrique afin de faire vibrer les bras du résonateur à la première fréquence propre qui correspond à un mode de vibration en flexion planaire des bras.

On a constaté que, du fait de la structure anisotrope du résonateur, les déplacements en flexion planaire d'un bras induisaient élastiquement la torsion des bras autour de leur axe longitudinal. Ainsi, les mouvements d'oscillation en flexion planaire induisent un deuxième mode de vibration en torsion quasi-statique des bras. En d'autres termes, le mode de vibration en torsion est couplé élastiquement au mode de vibration en flexion planaire.

Or, lorsque le résonateur est exposé à une accélération selon un axe sensible orthogonal au plan du résonateur, les bras fléchissent de manière que leur extrémité libre soit hors du plan du résonateur. La fréquence propre du mode de vibration combiné en flexion et en torsion s'en trouve alors légèrement modifiée de l'ordre de 1 ppm (parties par million ou 10⁻⁶) pour une accélération d'intensité équivalente à la gravité terrestre "1 g", cette unité sera notée par la suite "ppm/g". On a constaté que la variation de la fréquence propre est linéairement proportionnelle à l'accélération subie.

Cette propriété est un inconvénient majeur pour un usage en tant que résonateur pour une montre, mais elle rend le résonateur sensible à l'accélération.

Cependant, un tel résonateur est trop peu sensible à l'accélération pour un usage comme accéléromètre.

### Divulgation de l'invention

Pour résoudre ces problèmes, l'invention propose un accéléromètre du type décrit précédemment, caractérisé en ce que le couplage est obtenu de manière cinétique par l'agencement sur chaque bras d'un balourd dont le centre de gravité est décalé par rapport au plan de référence de façon à induire une torsion des bras lors de leurs oscillations transversales.

Selon d'autres caractéristiques de l'invention :
- un balourd est agencé sous l'extrémité libre de chaque bras ;
- les balourds sont réalisés venus de matière avec les bras ;
- les balourds forment des masses sismiques qui favorisent la flexion des bras hors du plan de référence lorsque l'accéléromètre est soumis à une accélération selon son axe sensible ;
- le résonateur est réalisé en un matériau monocristallin ;
- le résonateur est réalisé en silicium qui présente des propriétés mécaniques orthotropes ;
- les moyens d'actuation comportent une couche piézoélectrique en nitrure d'aluminium sur une face de chaque bras ; et
- les moyens d'actuation excitent le résonateur de manière électrostatique.

### Brève description des dessins

D'autres caractéristiques et avantages de l'invention apparaîtront au cours de la lecture de la description détaillée qui va suivre pour la compréhension de laquelle on se reportera aux dessins annexés parmi lesquels :
- la figure 1 est une vue en perspective qui représente un résonateur en forme de diapason réalisé selon les enseignements de l'invention ;
- la figure 2 est une vue en perspective qui représente le résonateur de la figure 1 en oscillation selon un mode de vibration en flexion planaire ;
- la figure 3 est une vue similaire à celle de la figure 1 qui représente le résonateur de la figure 1 en oscillation selon un mode de vibration en torsion ;
- la figure 4 est une vue en perspective qui représente le résonateur de la figure 1 soumis à une accélération selon son axe sensible ; et
- la figure 5 est une vue en bout selon un axe longitudinal qui représente le résonateur de la figure 1 en oscillation selon un mode combiné en flexion planaire et en torsion.

### Mode(s) de réalisation de l'invention

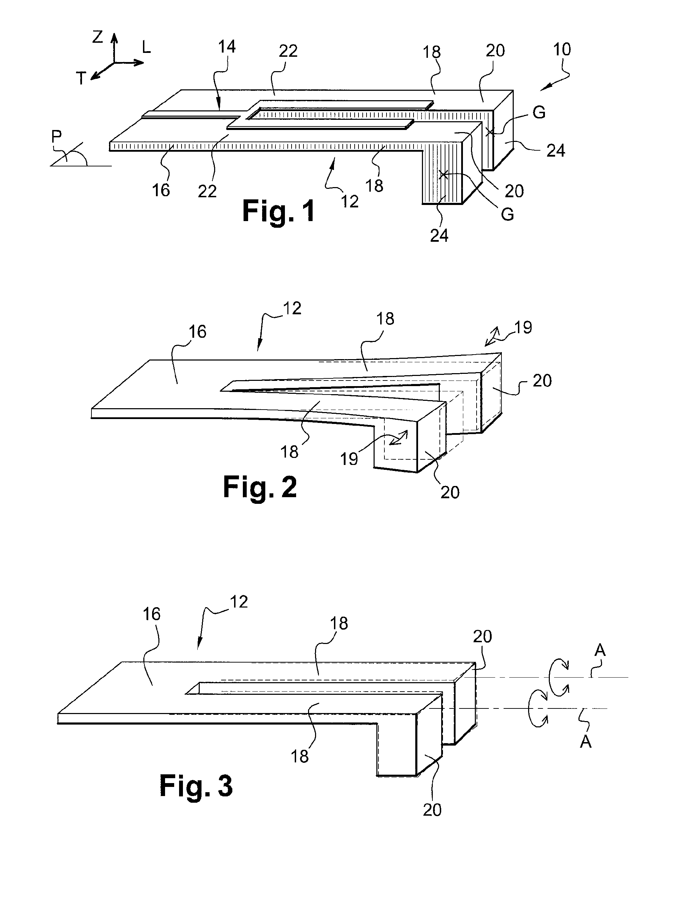

Pour la suite de la description on adoptera à titre non limitatif des orientations longitudinale "L" et transversale "T" ainsi qu'un axe sensible "Z" perpendiculaire aux orientations longitudinale et transversale. Ces orientations sont indiquées par le trièdre "L, Z, T" de la figure 1.

Par la suite, des éléments identiques ou analogues seront indiqués par des mêmes numéros de référence.

On a représenté à la figure 1 un accéléromètre résonant 10 qui comporte un résonateur 12 qui est mis en vibration par le biais de moyens d'actuation 14. L'accéléromètre 10 est susceptible de mesurer une accélération suivant un axe sensible "Z" qui est représenté de manière non limitative selon un axe vertical orienté de bas en haut aux figures.

Le résonateur 12 a la forme d'un diapason qui comporte une base transversale 16 en forme de plaque longitudinale transversale depuis laquelle s'étendent longitudinalement vers l'avant deux bras parallèles 18. Les bras 18 ont une forme de lamelle d'axe principal "A" longitudinal qui s'étendent dans le même plan que la base 16. Le résonateur 12 s'étend ainsi dans un plan longitudinal transversal de référence "P" qui est orthogonal à l'axe sensible "Z".

Les bras 18 ont des dimensions identiques. Les bras 18 comportent une extrémité avant libre 20 et leur extrémité arrière 22 est encastrée dans la base 16.

Les bras 18 et la base 16 sont réalisés en une pièce venue de matière, par exemple en silicium, en quartz ou encore en métal.

Le résonateur 12 est susceptible de vibrer selon au moins deux modes de vibration.

Un premier mode de vibration "M1" en flexion planaire est représenté à la figure 2. Lorsque le résonateur 12 est excité à une première fréquence propre "F1" correspondant à ce premier mode de vibration "M1", les bras 18 oscillent en flexion dans le plan de référence "P" à la manière de poutres encastrées dans la base 16. Ainsi, les extrémités libres 20 des bras 18 se déplacent transversalement par rapport à leur position initiale comme indiqué par les flèches 19.

Ce premier mode de vibration "M1" est dit évanescent car les bras 18 oscillent simultanément à la même fréquence "F1" en opposition de phase l'un par rapport à l'autre de manière que les forces d'inertie induites par les oscillations des bras 18 s'annulent mutuellement sans déséquilibrer la base 16.

Un deuxième mode de vibration "M2" en torsion est représenté à la figure 3. Lorsque le résonateur 12 est excité à une deuxième fréquence propre "F2" correspondant à ce deuxième mode de vibration "M2", les bras 18 oscillent en torsion autour de leur axe longitudinal "A" comme indiqué par les flèches en arc de cercle.

Ce deuxième mode de vibration "M2" est aussi évanescent car les bras 18 oscillent simultanément à la même fréquence "F2" en opposition de phase l'un par rapport à l'autre de manière que les forces d'inertie induites par les oscillations des bras 18 s'annulent mutuellement sans déséquilibrer la base 16.

De manière connue, les moyens d'actuation du résonateur 12 peuvent être de type piézoélectrique ou de type électrostatique.

Selon une variante avantageuse de l'invention, le résonateur est excité par effet piézoélectrique, par exemple, par l'intermédiaire d'une couche de nitrure d'aluminium, aussi connu sous l'acronyme "AIN", comprise entre deux électrodes. Comme indiqué sur la figure 1 représentant le résonateur 12, le couplage piézoélectrique est réalisé grâce à un dépôt de nitrure d'aluminium dans la région centrale du bras 18, à l'endroit où les déformations d'allongement sont les plus importantes. Cette zone rectangulaire se prolonge vers l'arrière le long des bras 18 par l'intermédiaire d'une bande mince jusqu'à une zone de connexion sur laquelle peut être soudé un fil de connexion électrique. La couche de nitrure d'aluminium est recouverte d'une couche conductrice (platine, aluminium, AISi ou autre alliage conducteur), couche qui est aussi déposée directement sur le substrat pour former des plots de connexion électrique à ce dernier.

Dans le cas où le silicium formant substrat ne serait pas dopé, il y aurait lieu de prévoir une seconde électrode entre le substrat et la couche de nitrure d'aluminium. Cette seconde électrode est, de préférence, réalisée en platine, matériau se prêtant particulièrement bien à la croissance du nitrure d'aluminium.

Le substrat est par exemple une plaque de silicium 10 dont la face inférieure est en oxyde de silicium. De telles plaques sont appelées "SOI" ce qui signifie silicium sur isolant.

Selon une autre variante de l'invention, les moyens d'actuation 14 peuvent aussi être du type électrostatique. Dans ce cas ils comprendront deux électrodes dont l'une pourra être réalisée sur la face transversale ou longitudinale de l'extrémité libre des bras et l'autre sur un support disposé en regard de la première. Par l'application d'une tension alternative entre les deux électrodes il est possible de faire osciller les bras. Les tensions requises sont, toutefois, élevées, ce qui rend ce type d'actuation moins attrayant par rapport à la variante piézoélectrique.

L'utilisation de résonateurs en silicium est, du fait de leur résistance élevée, notamment par rapport aux diapasons en quartz, particulièrement adaptée pour des accéléromètres 10 dits de choc ou "high shock", qui sont exposés à des accélérations de très forte intensité.

Selon les enseignements de l'invention, les deux modes de vibration en flexion planaire "M1" et en torsion "M2" sont couplés cinétiquement de manière que l'excitation du mode de vibration en flexion planaire "M1" induise des oscillations selon le mode de vibration en torsion "M2". Le résonateur 12 comporte ainsi un mode de vibration combiné "M12" en flexion planaire et en torsion qui présente une fréquence propre combinée "F12" qui est inférieure à la fréquence propre "F1" du premier mode d'oscillation "M1" non couplé.

A cet effet, une masse 24 est agencée à l'extrémité libre 20 des bras 18 de manière non symétrique par rapport au plan de référence "P". Plus précisément, chaque masse 24 est agencée sous la face inférieure de l'extrémité libre 20 du bras 18 associé.

Les masses 24 forment ainsi des balourds 24 lors de l'oscillation en torsion des bras 18 autour de leur axe longitudinal "A".

De préférence, le centre de gravité "G" de chaque balourd est agencé à la même distance du plan de référence "P", ici au droit de l'axe longitudinal de chaque bras 18 afin que les mouvements de torsion induits par les déplacements des extrémités lors du mode de vibration en flexion planaire "M1" soient identiques pour les deux bras 18. Dans l'exemple représenté aux figures, les balourds 24 sont identiques en masse et en dimensions, et ils sont agencés de manière identique sous chacun des bras 18.

De manière générale, les deux bras équipés de leur balourd 24 ont des moments d'inertie identiques au moins selon leur axe principal "A".

Lorsque le résonateur 12 n'est soumis à aucune accélération, ses bras 18 sont compris dans le plan de référence "P". Sa fréquence propre "F12" est alors égale à une fréquence propre de référence "F12ref".

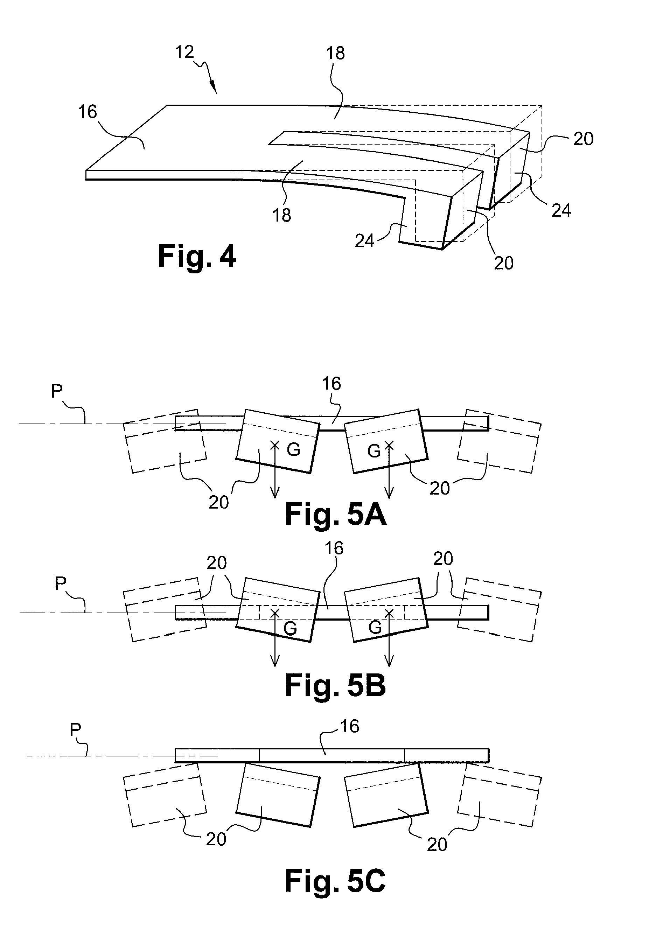

Ainsi, comme représenté à la figure 5A, lorsque les bras 18 oscillent en flexion planaire, les extrémités libres 20 des bras 18 se déplacent transversalement en oscillation dans le plan de référence. Le déplacement transversal du balourd 24 est retardé par la force d'inertie qui s'applique à son centre de gravité "G". Le centre de gravité "G" du balourd 24 étant décalé vers le bas par rapport à la ligne de déplacement des extrémités libres 20, la force d'inertie qui est opposée au déplacement des bras 18 retient le balourd 24 induit un couple sur le bras 18, provoquant ainsi une torsion de l'extrémité libre 20 du bras 18.

Ainsi, l'extrémité libre 20 de chaque bras 18 est animée d'oscillations en flexion planaire et d'oscillations en torsion qui, parce qu'elles sont couplées, sont en phase l'une avec l'autre.

Lorsque le résonateur 12 est soumis à une accélération positive dirigée de haut en bas selon l'axe sensible "Z", comme représenté à la figure 4, les bras 18 fléchissent conjointement vers le bas hors du plan de référence à la manière de poutres encastrées, les flèches des bras 18 étant identiques. L'extrémité libre 20 des bras 18 est alors agencée au-dessous du plan de référence.

Comme représenté à la figure 5C, on a alors constaté que la fréquence propre "F12" du mode de vibration combiné "M12" en flexion planaire et en torsion diminue par rapport à la fréquence propre de référence "F12ref". En effet, le décalage entre le centre de gravité des balourds 24 et le plan de référence "P" augmente, ce qui augmente le moment d'inertie des bras 18 par rapport à leur axe longitudinal "A", provoquant ainsi une augmentation d'amplitude des oscillations des bras 18.

Au contraire, lorsque le résonateur 12 est soumis à une accélération négative qui est dirigée de bas en haut selon l'axe sensible "Z", comme illustré à la figure 5B, les bras 18 fléchissent conjointement vers le haut hors du plan de référence à la manière de poutres encastrées, les flèches des bras 18 étant identiques. L'extrémité libre 20 des bras 18 est alors agencée au-dessus du plan de référence.

On a alors constaté que la fréquence propre "F12" du mode de vibration combiné "M12" en flexion planaire et en torsion augmente par rapport à la fréquence propre de référence "F12ref". En effet, le décalage entre le centre de gravité des balourds 24 et le plan de référence "P" diminue, ce qui diminue le moment d'inertie des bras 18 par rapport à leur axe longitudinal initial "A", provoquant ainsi une diminution d'amplitude des oscillations des bras 18.

La fréquence propre "F12" de vibration du résonateur 12 est ainsi linéairement proportionnelle à l'amplitude de la flèche de l'extrémité libre 20 des bras 18. La fréquence propre "F12" de vibration du résonateur 12 varie ainsi linéairement par rapport à l'intensité de l'accélération, l'intensité pouvant être négative ou positive suivant son sens selon la direction de l'axe sensible "Z".

Avantageusement, les balourds 24 sont réalisés en une seule pièce venue de matière avec le résonateur 12. Par exemple, le résonateur 12 est fabriqué par attaque profonde d'une plaque de silicium selon des procédés d'usinage déjà connus.

Le résonateur 12 est ici constitué d'un matériau monocristallin orthotrope tel que du silicium dont l'axe mécanique est orienté selon une direction longitudinale.

Selon une variante de l'invention, le résonateur 12 est réalisé en matériau monocristallin anisotrope tel que du quartz ou du silicium. Le couplage entre le premier mode de vibration en flexion planaire "M1" et le deuxième mode de vibration en torsion "M2" est alors réalisé à la fois de manière cinétique et élastique.

Les balourds 24 forment avantageusement des masses sismiques qui favorisent la flexion des bras 18 perpendiculairement au plan de référence "P" pour augmenter encore la sensibilité de l'accéléromètre 10.

On a aussi constaté que la sensibilité de la fréquence propre "F12" à l'accélération est indépendante de la largeur transversale des bras 18.

L'accéléromètre 10 équipé d'un résonateur 12 selon l'invention présente une grande sensibilité sur une vaste plage d'intensités d'accélération.

En effet, la sensibilité à l'accélération du résonateur 12 en flexion est fortement amplifiée en remplaçant ou en améliorant le couplage élastique des deux modes de vibration "M1, M2" par un couplage cinétique équivalent.

Un tel accéléromètre 10 permet par exemple d'atteindre une sensibilité pouvant dépasser 3500 ppm/g dans une plage de fréquences "F12" qui s'étend de 10 kHz à 100 kHz.

De plus, la variation de la fréquence propre "F12" étant linéairement proportionnelle à l'intensité de l'accélération mesurée, l'utilisation de l'accéléromètre n'est pas limitée à une plage restreinte de mesures.

La fréquence propre d'un tel résonateur 12 est susceptible de varier légèrement en fonction de la température. Cependant, le résonateur 12 réalisé selon les enseignements de l'invention est suffisamment sensible à l'accélération pour que la température n'altère pas sensiblement la mesure de l'intensité de l'accélération.

De plus, le résonateur 12 proposé présente une structure très résistante aux chocs, qui peut par exemple supporter une accélération selon son axe sensible "Z" d'une intensité de plus de 10000 g et/ou une accélération de la rotation d'une intensité de plus de 7000 g.mm sans que le résonateur 12 ne soit endommagé. De plus, le résonateur 12 est hautement résilient de manière que le résonateur 12 puisse récupérer ses propriétés d'origines après un choc.

## Revendications

1. Accéléromètre (10) résonant qui est susceptible de mesurer l'intensité d'une accélération selon un axe sensible (Z) et qui comporte :
- un résonateur (12) en forme de diapason comportant deux bras (18) longitudinaux plats identiques parallèles entre eux qui s'étendent depuis une extrémité encastrée (22) jusqu'à une extrémité libre (20) dans un plan de référence (P) orthogonal à l'axe sensible (Z), les deux bras (18) étant susceptibles d'osciller simultanément selon un premier mode de vibration (M1) en flexion planaire dans lequel les extrémités libres (20) oscillent transversalement et selon un deuxième mode de vibration (M2) en torsion autour de leur axe longitudinal, les deux modes de vibration (M12) étant couplés l'un à l'autre ; et
- des moyens d'actuation (14) qui excitent l'oscillation des bras (18) du résonateur (12) à une fréquence propre de vibration (F12) ;
une accélération selon l'axe sensible (Z) provoquant une flexion conjointe des bras (18) hors du plan de référence (P), la fréquence propre (F12) du résonateur (12) variant linéairement par rapport à l'amplitude de la flèche des bras (18),
**caractérisé en ce que** le couplage est obtenu de manière cinétique par l'agencement sur chaque bras (18) d'un balourd (24) dont le centre de gravité (G) est décalé par rapport au plan de référence (P) de façon à induire une torsion des bras (18) lors de leurs oscillations transversales.

2. Accéléromètre (10) selon la revendication précédente, **caractérisé en ce qu'**un balourd (24) est agencé sous l'extrémité libre (20) de chaque bras (18).

3. Accéléromètre (10) selon la revendication précédente, **caractérisé en ce que** les balourds (24) sont réalisés venus de matière avec les bras (18).

4. Accéléromètre (10) selon l'une quelconque des revendications précédentes, **caractérisé en ce que** les balourds (24) forment des masses sismiques qui favorisent la flexion des bras (18) hors du plan de référence lorsque l'accéléromètre (10) est soumis à une accélération selon son axe sensible (Z).

5. Accéléromètre (10) selon l'une quelconque des revendications précédentes, **caractérisé en ce que** le résonateur (12) est réalisé en un matériau monocristallin.

6. Accéléromètre (10) selon la revendication précédente, **caractérisé en ce que** le résonateur (12) est réalisé en silicium.

7. Accéléromètre (10) selon l'une quelconque des revendications précédentes, **caractérisé en ce que** le résonateur (12) présente des propriétés mécaniques orthotropes.

8. Accéléromètre (10) selon l'une quelconque des revendications précédentes, **caractérisé en ce que** les moyens d'actuation (14) sont de type piézoélectrique et comportent une couche de nitrure d'aluminium déposée sur une face de chaque bras (18).

9. Accéléromètre (10) selon l'une quelconque des revendications 1 à 7, **caractérisé en ce que** les moyens d'actuation (14) sont de type électrostatique.

10. Accéléromètre (10) selon la revendication précédente, **caractérisé en ce que** les moyens d'actuation de type électrostatique (14) sont agencés à l'avant de l'extrémité libre (20) des bras (18).
